# EUROPÄISCHE PATENTANMELDUNG

(11) **EP 1 115 030 A2**
(43) Veröffentlichungstag der Anmeldung: **11.07.2001**
(21) Anmeldenummer: 00124722.0
(22) Anmeldetag: 13.11.2000
(51) Int. Cl.: G03F 7/20

(54) **Optisches System**

(30) Priorität: 05.01.2000 DE 10000193
(71) Anmelder: Carl Zeiss, 89518 Heidenheim (Brenz) (DE); Carl-Zeiss-Stiftung, trading as Carl Zeiss, 89518 Heidenheim (Brenz) (DE)
(72) Erfinder: Wagner, Christian, 73430 Aalen (DE); Becker, Jochen, 73447 Oberkochen (DE); Xalter, Stefan, 73447 Oberkochen (DE); Holderer, Hubert, 89551 Königsbronn (DE); Von Bünau, Rudolf, 73457 Essingen (DE); Hummel, Wolfgang, 73525 Schwäbisch Gmünd (DE)
(74) Vertreter: Ostertag, Ulrich, Dr.

(57) **Zusammenfassung**

Ein optisches Element (1) eines optischen Systems besitzt mindestens einen gegen den Atmosphärendruck abgedichteten und von begrenzenden Flächen umschlossenen Raum (5) mit einer Fluidfüllung. Zumindest eine der begrenzenden Flächen des Raums (5) wird zumindest teilweise von Beleuchtungslicht beaufschlagt. Er ist so ausgestaltet, daß eine Änderung des Fluiddrucks innerhalb des Raums (5) zu einer Änderung nicht rotationssymmetrischer Abbildungseigenschaften des optischen Elements (1) mit n-zähliger Symmetrie führt. Hierzu steht eine Fluidquelle mit dem Raum über eine Fluidzuführleitung (17) in Fluid-Verbindung. Weiterhin ist eine Steuereinrichtung für den Druck der Fluidfüllung vorgesehen.

## Beschreibung

Die Erfindung betrifft ein optisches System, insbesondere eine Projektions-Belichtungsanlage der Mikrolithographie, insbesondere mit schlitzförmigem Bildfeld oder nicht rotationssymmetrischer Beleuchtung,
a) mit einem optischen Element mit mindestens einem gegen den Atmosphärendruck abgedichteten und von begrenzenden Flächen umschlossenen Raum mit einer Fluidfüllung, wobei zumindest eine der begrenzenden Flächen zumindest teilweise vom Beleuchtungslicht beaufschlagt wird;
b) einer Fluidquelle, die mit dem Raum über eine Fluidzuführleitung in Fluid-Verbindung steht; und
c) einer Steuereinrichtung für den Druck der Fluidfüllung.

Ein solches System ist in der US 4 676 631 A beschrieben. Dort wird zur Anpassung der Projektionsvergrößerung einer Projektions-Belichtungsanlage ein optisches Element eingesetzt, das zwischen einer Projektionsoptik und einem Laser angeordnet ist. Das optische Element besteht aus zwei transparenten Platten, die mit einer gemeinsamen Fassung einen gasdichten Raum begrenzen. Die transparenten Platten werden über einen steuerbaren internen Gasdruck definiert so verformt, daß sie wie eine Linse steuerbarer positiver Brechkraft wirken. Mit einer derartigen Anordnung ist nur die Einstellung der Projektionsvergrößerung, also einer rotationssymmetrischen Abbildungseigenschaft, möglich. Nicht rotationssymmetrische Abbildungseigenschaften, z.B. zur Kompensation nicht rotationssymmetrischer Abbildungsfehler, sind dagegen nicht einstellbar.

Gerade bei Projektions-Belichtungsanlagen, aber auch bei anderen optischen Systemen, hat sich herausgestellt, daß deren Abbildungsqualität oftmals durch einen veränderlichen Astigmatismus gemindert wird. Ein veränderlicher Astigmatismus entsteht z.B. durch nicht rotationssymmetrische lichtinduzierte Effekte, wie Erwärmung oder "compaction", die eine entsprechende astigmatische Ausdehnung bzw. Brechungsindexverteilung im optischen Element zur Folge haben. Auch in Festkörper-Lasermedien treten veränderliche, z.B. von der Pumpintensität abhängige, astigmatische Linseneffekte auf. Dabei wird entweder durch das Pumplicht oder das oszillierende Laserlicht eine Doppelbrechung induziert oder eine bereits im Lasermedium vorhandene Doppelbrechung verstärkt, was oftmals zu einem veränderlichen Astigmatismus im Laserresonator führt.

Es ist z.B. aus der EP 0 678 768 A2 bekannt, den lichtinduzierten astigmatischen Abbildungsfehler in einer Linse durch einen mittels nicht rotationssymmetrischer Temperierung des Linsenmaterials künstlich hervorgerufenen Astigmatismus zu kompensieren. Dieser Kompensationsmechanismus hat, bedingt durch die schlechte Wärmeleitung der meisten Linsenmaterialien, jedoch unerwünscht lange Zeitkonstanten.

Außerdem sind für bestimmte optische Anwendungen weitere Umstände denkbar, in denen es wünschenswert ist, einen veränderlichen Astigmatismus definiert zu erzeugen.

Es ist daher die Aufgabe der vorliegenden Erfindung, ein optisches System der eingangs genannten Art derart weiterzubilden, daß in diesem System ein zusätzlicher veränderlicher Astigmatismus erzeugt werden kann, der beispielsweise für Kompensationszwecke einsetzbar ist.

Diese Aufgabe wird erfindungsgemäß dadurch gelöst, daß der umschlossene Raum so ausgestaltet ist, daß eine Änderung des Fluiddrucks innerhalb des mindestens einen Raums zu einer Änderung nicht rotationssymmetrischer Abbildungseigenschaften des optischen Elements führt, welche bezogen auf die optische Achse des optischen Elements eine n-zählige Symmetrie aufweisen, wobei n größer ist als 1.

Die Erfindung führt also den in der US 4 676 631 A offenbarten Grundgedanken der Änderung der optischen Eigenschaften eines Elements über den Gasdruck weiter und erschließt durch die druckbedingte Änderung der nicht rotationssymmetrischen Abbildungseigenschaften mit n-zähliger Symmetrie nun auch die Möglichkeit zur Kompensation auftretender entsprechender Abbildungsfehler.

Die Änderung des Fluiddrucks innerhalb des mindestens einen Raums kann zu einer Änderung der astigmatischen Eigenschaften des optischen Elements führen. Der Astigmatismus ist ein besonders häufig auftretender nicht rotationssymmetrischer Abbildungsfehler mit zweizähliger Symmetrie, der durch ein derartiges optisches Element korrigiert werden kann.

Bei einer bevorzugten Ausgestaltung der Erfindung ist zumindest der Bereich der den Raum begrenzenden Flächen, der vom Beleuchtungslicht bestrahlt wird, zumindest teilweise von einem elastisch verformbaren Medium gebildet, wobei die Randkontur des elastisch verformbaren Flächenbereichs nicht rotationssymmetrisch ist. Ein elastisch verformbares Medium mit nicht rotationssymmetrischer Randkontur wölbt sich in ausgewählten, zueinander senkrecht stehenden Ebenen derart, daß dort unterschiedliche Krümmungen vorliegen. Je nach Druck der Fluidfüllung ändert sich das Brennweitenverhältnis eines solchen astigmatischen optischen Elements in aufeinander senkrecht stehenden Meridionalebenen. Insgesamt ergibt sich ein einfach zu realisierendes Kompensationselement für einen veränderlichen Astigmatismus.

Die Randkontur kann bezogen auf die optische Achse des optischen Elements eine n-zählige Symmetrie aufweisen, wobei n größer ist als 1. Die auf diese Weise an die Symmetrie des zu korrigierenden Abbildungsfehlers anpaßbare Randkontur führt zur Möglichkeit, bestimmte n-zählige Abbildungsfehler gezielt zu korrigieren, andere Abbildungseigenschaften mit anderer n-zähliger Symmetrie jedoch unverändert zu belassen.

Die Randkontur kann elliptisch geformt sein. Eine derartige Randkontur läßt sich einfach spezifizieren und daher automatisiert fertigen. Das Verhältnis der Abbildungseigenschaften in den zueinander senkrecht stehenden Meridionalebenen kann auf einfache Weise über das Längenverhältnis der Hauptachsen der Ellipse eingestellt werden.

Alternativ kann die Randkontur die Form eines Vielecks haben. Derartige Randkonturen sind einfach herstellbar.

Bevorzugt wird das elastisch verformbare optische Medium in seinem Randbereich von einer Halteeinrichtung gehalten, wobei die Form der Haltefläche, an der das optische Medium an der Halteeinrichtung anliegt, die Randkontur des elastisch verformbaren Flächenbereichs vorgibt. Auf diese Weise läßt sich eine nicht rotationssymmetrische Randkontur eines elastisch verformbaren Mediums einfach realisieren.

Das optische Medium kann ein Pellicle sein. Derartige optische Membranen haben eine sehr gute optische Qualität und lassen sich durch relativ moderate Fluiddruck-Änderungen verbiegen.

Alternativ kann das optische Medium eine Quarzplatte oder eine Platte aus CaF₂ sein. Quarzplatten haben gute optische Eigenschaften und lassen sich mit derart geringen Stärken herstellen, daß sie sich auch durch moderate Druckänderungen definiert deformieren lassen. Platten aus CaF₂ sind insbesondere in dem für die Projektions-Belichtung interessanten ultravioletten Wellenlängenbereich gut transparent.

Das optische Medium kann eine Reflexionsbeschichtung aufweisen. Das optische Element ist dann als abbildungskorrigierender Spiegel einsetzbar.

Bei einer alternativen Ausführungsform ist zumindest ein Bereich einer Fläche der den Raum begrenzenden Flächen vom Beleuchtungslicht durchstrahlt und wird von mindestens einer starren optischen Oberfläche mit in aufeinander senkrecht stehenden Ebenen unterschiedlicher Krümmung gebildet. Bei dieser Ausführungsform wird der Effekt ausgenutzt, daß die Änderung der Ablenkung transmittierter Lichtstrahlen infolge einer druckbedingten Brechungsindexänderung der Fluidfüllung vom Absolutwert des Einfallsbzw. Ausfallswinkels an den optischen Grenzflächen des Raums für die Fluidfüllung abhängt. Durch Änderung des Fluiddrucks ist daher auch bei dieser Ausführungsform eine Einstellung des Astigmatismus des optischen Elements möglich.

Dabei wird bevorzugt das optische Element aus einer Kombination von mindestens zwei optischen Komponenten gebildet, die jeweils mindestens einen gegen den Atmosphärendruck abgedichteten und von begrenzenden Flächen umschlossenen Raum mit einer Fluidfüllung, der vom Beleuchtungslicht durchstrahlt wird, umfassen, wobei die optischen Komponenten zumindest im Bereich einer Fläche der die jeweiligen Räume begrenzenden Flächen je mindestens eine optische Oberfläche mit in aufeinander senkrecht stehenden Ebenen unterschiedlicher Krümmung aufweisen; und mittels der Steuereinrichtung wird eine unabhängige Steuerung des Drucks der Fluidfüllung in den den optischen Komponenten zugeordneten Räumen gewährleistet. Über den Einsatz mehrerer optischer Komponenten mit fluiddruckabhängigem Astigmatismus lassen sich größere Bereiche einzustellender Astigmatismen abdecken.

Das optische Element kann in diesem Falle so ausgeführt sein, daß es bei gleichem Druck der Fluidfüllung in den den optischen Komponenten zugeordneten Räumen im wesentlichen rotationssymmetrische Abbildungseigenschaften hat. Das optische Element weist dann in einem neutralen Zustand, bei dem gleicher Druck in beiden Räumen herrscht, im wesentlichen keinen Astigmatismus auf. In einer optische Anordnung, bei der rotationssymmetrische Abbildungseigenschaften gefordert sind, z.B. lichtinduziert entstehende Astigmatismen, lassen sich dann ausgehend von diesem neutralen Zustand kompensieren.

Alternativ kann das optische Element so ausgeführt sein, daß es bei gleichem Druck der Fluidfüllung in den den optischen Komponenten zugeordneten Räumen astigmatische Abbildungseigenschaften hat. Ein derartiges optisches Element ist in Situationen einsetzbar, in denen astigmatische Abbildungseigenschaften, z.B. zur Abbildung von streifenförmigen Objekten, gefordert sind, oder in denen von einem von vornherein zu kompensierenden Ausgangs-Astigmatismus auszugehen ist, um den herum dann eine Feineinstellung möglich ist.

Die optische Oberfläche mit in aufeinander senkrecht stehenden Ebenen unterschiedlicher Krümmung kann die Oberfläche einer Zylinderlinse sein. Durch eine derartige Ausgestaltung ist eine Entkopplung der einstellbaren Abbildungseigenschaften in zwei aufeinander senkrecht stehenden Ebenen möglich. Dabei wird zur Einstellung der Abbildungseigenschaften in einer dieser Ebenen in einem der beiden Räume der entsprechende Gasdruck eingestellt. Die Abbildungseigenschaften in der dazu senkrechten Ebene bleiben davon unbeeinflußt.

Die Zylinderlinse kann eine plankonvexe Zylinderlinse sein. Die Verwendung konvexer den Raum begrenzender Flächen bietet Vorteile bei der Fluidzuführung, da im Bereich eines die optischen Komponenten umschließenden Gehäuses, also im Randbereich der optischen Komponenten, konvexe optische Komponenten den jeweils größten Abstand voneinander aufweisen. Dies ist insbesondere deshalb von Vorteil, da der fluidgefüllte Raum so klein wie möglich ausgeführt sein sollte, um einerseits durch geringe Zu- und Abfuhr von Fluid eine erforderliche Druckänderung bzw. Verformung zu erzielen und andererseits das optische Element bauklein zu halten.

Die Steuereinrichtung kann mit einer die Abbildungseigenschaften des optischen Elements und/oder des optischen Systems überwachenden Sensoranordnung in Signalverbindung stehen, wobei die Steuereinrichtung in Abhängigkeit von den übermittelten Signaldaten der Sensoranordnung einen Druck der Fluidfüllung vorgibt. Eine derartige Überwachung der Abbildungseigenschaften führt zur Möglichkeit einer Regelung des Fluiddrucks bzw. der Fluiddrücke zur automatischen Kompensation von Abbildungsfehlern.

Die Sensoranordnung kann einen positionsempfindlichen Sensor aufweisen. Mit einem derartigen Sensor ist auf einfache Weise eine Überwachung der Abbildungseigenschaften des optischen Elements und/oder des optischen Systems möglich. Eine kostengünstige Ausführungsform eines derartigen positionsempfindlichen Sensors ist z.B. ein Quadrantendetektor.

Bevorzugt ist der positionsempfindliche Sensor ein CCD-Array. Mit einem derartigen Sensor ist eine präzise Erfassung der Abbildungseigenschaften und zu ihrer Überwachung der Einsatz bekannter Bildverarbeitungsalgorithmen möglich.

Die Steuereinrichtung kann so ausgelegt sein, daß sie sowohl Unterdrücke als auch Überdrücke zu erzeugen vermag. Dies erhöht den Einstellbereich der astigmatischen Abbildungseigenschaften des optischen Elements. Wird ein optisches Element mit einer mittels des Fluiddrucks elastisch verformbaren Begrenzungsfläche eingesetzt, kann bezogen auf den umschlossenen Raum durch einen Unterdruck eine konkav und durch einen Überdruck eine konvex geformte Begrenzungsfläche realisiert werden.

Bevorzugt ist das Fluid ein Gas. Über eine Gasdruckänderung ist bei Verwendung einer elastisch verformbaren Begrenzungsfläche eine Feineinstellung der Formänderung erzeugbar.

Wird ein vom Beleuchtungslicht durchstrahltes optisches Element und ein Edelgas als Fluid eingesetzt, resultieren besonders vorteilhafte optische Eigenschaften insbesondere hinsichtlich der Transmission des Fluids. Eine Reaktion des Füllgases mit den optischen Komponenten bzw. den Gehäuseflächen ist praktisch ausgeschlossen.

Alternativ kann das Fluid eine Flüssigkeit sein. Mit einer Flüssigkeit läßt sich eine relativ schnelle Anpassung der Abbildungseigenschaften des optischen Elements bei Verwendung einer elastisch verformbaren Begrenzungsfläche realisieren, da zur Verformung der Begrenzungsfläche nur eine verglichen mit einem Gas kleine Zu- bzw. Abfuhr an Fluidvolumen erforderlich ist.

Ausführungsbeispiele der Erfindung werden nachfolgend anhand der Zeichnung näher erläutert; es zeigen:
- Figur 1:: einen Meridionalschnitt eines gasgefüllten optischen Transmissionselements mit deformierbaren optischen Flächen;
- Figur 2:: eine Aufsicht auf das Transmissionselement von Figur 1, wobei zusätzlich eine Gasversorgungsanordnung für das Transmissionselement als Blockschaltbild dargestellt ist.
- Figur 3:: eine schematische Darstellung eines Ausschnitts des Transmissionselements von Figur 1, wobei der Gasdruck im Transmissionselement größer ist als der Umgebungsdruck;
- Figur 4:: einen Schnitt gemäß Linie IV-IV von Figur 3;
- Figur 5:: eine zu Figur 3 ähnliche Darstellung, wobei der Gasdruck im Transmissionselement kleiner ist als der Umgebungsdruck;
- Figur 6:: einen Schnitt gemäß Line VI-VI von Figur 5;
- Figur 7:: einen Meridionalschnitt eines alternativen gasgefüllten optischen Transmissionselements mit nicht elastisch verformbaren optischen Flächen; und
- Figur 8:: einen Schnitt gemäß Linie VIII-VIII von Figur 7, wobei zusätzlich eine Gasversorgungsanordnung des Transmissionselements als Blockschaltbild dargestellt ist.

Die in der Zeichnung dargestellten optischen Komponenten sind Teile einer Projektions-Belichtungsanlage der Mikrolithographie, mit deren Hilfe dort auftretende astigmatische Bildfehler kompensiert werden.

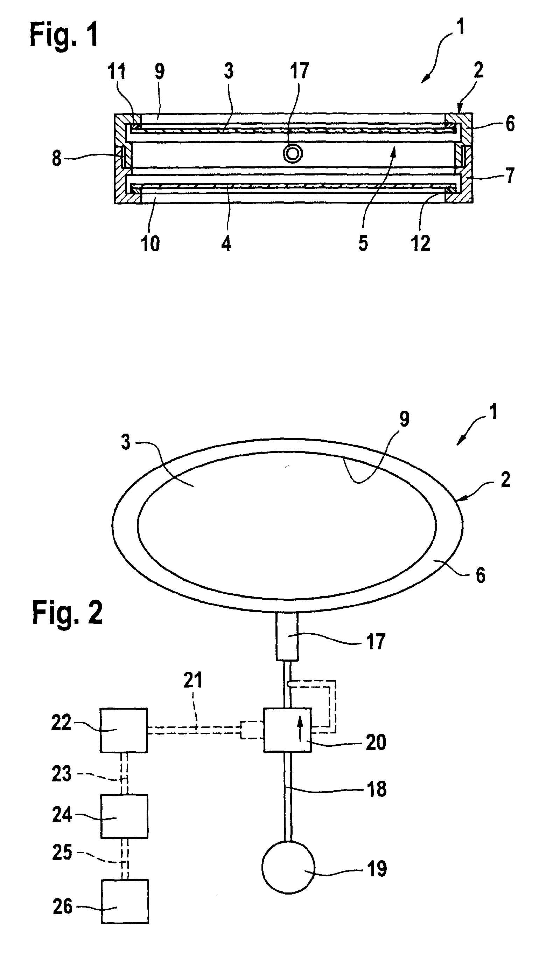

Ein in den Figuren 1 und 2 dargestelltes optisches Transmissionselement 1 weist eine Fassung 2 sowie zwei Pellicles 3, 4, d.h. optisch transparente Membranen mit einer Stärke von nur einigen Mikrometern, auf. Die Fassung 2 und die Pellicles 3, 4 begrenzen einen Gas-Füllraum 5.

Die Fassung 2 hat die Form eines elliptischen Zylinderkörpers (vgl. Figur 2). Die optische Achse des Transmissionselements 1 fällt mit der Schnittgerade der beiden Hauptebenen des elliptischen Zylinderkörpers, der durch die Fassung 2 vorgegeben ist, zusammen. Die Fassung 2 weist zwei Einzelfassungen 6, 7 für jeweils ein Pellicle 3, 4 auf, die über eine in Umfangsrichtung der Fassung 2 verlaufende Klebeschicht 8 gasdicht miteinander verklebt sind. Die Einzelfassungen 6, 7 weisen jeweils Aperturöffnungen 9, 10 auf, die von den Pellicles 3, 4 verschlossen werden. Die Aperturöffnungen 9, 10 haben eine elliptische Randkontur.

Zum gasdichten Abschluß des Gas-Füllraums 5 sind die Randbereiche der Pellicles 3, 4 mit einem elliptischen Umfangsbereich der Einzelfassungen 6, 7, der den Aperturöffnungen 9, 10 benachbart ist, über Klebeschichten 11, 12 verklebt.

Der Gas-Füllraum 5 steht über einen Einfüllstutzen 17 und eine Gas-Zuführleitung 18 (vgl. Fig. 2) mit einem Gas-Versorgungsbehälter 19 in Fluidverbindung.

Zur Gasfüllung wird ein Edelgas, z.B. Helium eingesetzt. Alternativ zu einem Gas kann auch eine Flüssigkeit, z.B. Wasser, eingesetzt werden. Voraussetzung für die Eignung eines Fluids zum Einsatz im Transmissionselement 1 sind ausreichend gute optische Eigenschaften (Brechungsindex, Transmission) im Bereich der Wellenlängen, die bei der Projektions-Belichtung eingesetzt werden. Bei der Verwendung des Transmissionselements in einem gespülten Projektionsobjektivs einer Projektions-Belichtungsanlage ist zu beachten, daß der Brechungsindex des Fluids im Transmissionselement vom Brechungsindex des Spülgases außerhalb des Transmissionselements verschieden sein muß. Bei den nachfolgend beschriebenen Ausführungsbeispielen des Transmissionselements 1 ist vorausgesetzt, daß der Brechungsindex im Innern der Fassung 2 jeweils größer ist als außerhalb davon.

Zur besseren Unterscheidbarkeit werden in der Zeichnung Gasleitungen durchgezogen und Signalleitungen gestrichelt wiedergegeben.

In der Gas-Zuführleitung 18 ist ein Druckregelventil 20 angeordnet, mit dem über den Druck in der Gas-Zuführleitung 18 der Druck im Gas-Füllraum 5 geregelt wird. Das Druckregelventil 20 steht über eine Signalleitung 21 mit einer Steuerschaltung 22 in Signalverbindung. Die Steuerschaltung 22 ist über eine Signalleitung 23 mit einer Belichtungs-Steuerungsschaltung 24 verbunden. Diese steht über eine Signalleitung 25 mit einem zweidimensionalen CCD-Array 26 in Signalverbindung.

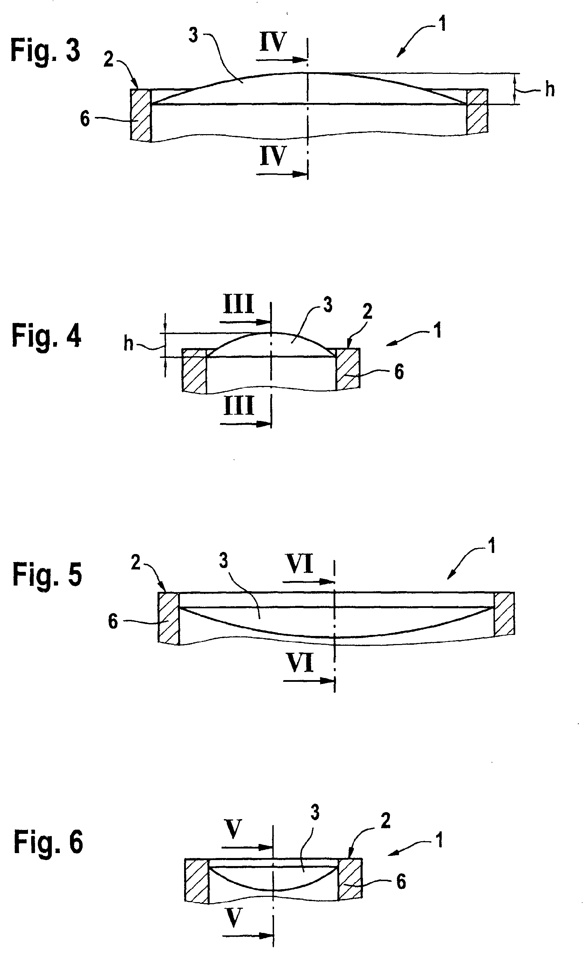

Die Figuren 3 und 4 zeigen schematisch die Deformation des Pellicles 3 bei einem Gasdruck im Gas-Füllraum 5, der größer ist als der Druck in der Umgebung des Transmissionselements 1. Aufgrund dieser Druckdifferenz wölbt sich das Pellicle 3 bezogen auf die Fassung 2 derart nach außen, daß das Zentrum des Pellicles 3 zum Niveau des in der Fassung eingespannten Randbereichs einen Abstand h aufweist. Diese Wölbung führt in der Meridionalebene, in der die lange Hauptachse der elliptischen Grundfläche des Pellicles 3 liegt (Schnittebene der Figuren 1, 3 und 5) zu einer geringeren Krümmung als in der dazu senkrechten Meridionalebene (Schnittebene der Figur 4). Diese unterschiedlichen Krümmungen führen in diesen beiden Meridionalebenen zu einem unterschiedlichen Brechungsverhalten des Transmissionselements 1.

Das in den Figuren 3 und 4 nicht dargestellte Pellicle 4 wölbt sich spiegelsymmetrisch zur auf der optischen Achse des Transmissionselements 1 senkrecht stehenden zentralen Mittelebene der Fassung 2 ebenfalls nach außen, woraus analog zum oben Beschriebenen unterschiedliche Abbildungseigenschaften in den beiden Meridionalebenen resultieren. Insgesamt stellt das Transmissionselement 1 bei diesen Druckverhältnissen daher eine Art bikonvexer astigmatischer Linse dar, deren Brennweite in der Meridionalebene, in der die längere Ellipsen-Hauptachse liegt, größer ist als in der dazu senkrechten Meridionalebene.

Analoge Verhältnisse ergeben sich, wenn im Gas-Füllraum 5 ein Druck herrscht, der geringer ist als der Druck in der Umgebung des Transmissionselementes 1. Diese Situation ist in den schematischen Figuren 5 und 6 dargestellt.

Das Pellicle 3 (und spiegelsymmetrisch dazu das Pellicle 4) wölbt sich nun bezogen auf die Fassung 2 nach innen, so daß insgesamt das Transmissionselement 1 eine Art bikonkaver astigmatischer Linse darstellt.

Das Transmissionselement 1 mit den elastisch verformbaren Pellicles 3, 4 funktioniert folgendermaßen:

Mit Hilfe des CCD-Arrays 26, das in einer Bildebene der optischen Anordnung der Projektions-Belichtungsanlage liegt, erfolgt eine Überwachung der Abbildungsqualität der optischen Anordnung. Die mittels des CCD-Arrays 26 abgebildeten Strukturen in der Bildebene werden über die Signalleitung 25 an die Belichtungs-Steuerungsschaltung 24 übertragen und dort, insbesondere hinsichtlich auftretender Abbildungsfehler, mit Hilfe bekannter Bildverarbeitungs-Algorithmen ausgewertet.

Aus den ermittelten Abbildungsfehlern berechnet die Belichtungs-Steuerungsschaltung 24 eine Sollwert-Vorgabe für die astigmatischen Abbildungseigenschaften des Transmissionselements 1, die über die Signalleitung 23 an die Steuerschaltung 22 übermittelt wird. Diese berechnet aus dieser Sollwert-Vorgabe einen Solldruck im Gas-Füllraum 5, der über die Signalleitung 21 als Vorgabewert dem Druckregelventil 20 übermittelt wird. Letzteres regelt den Druck im Gas-Füllraum 5 auf den vorgegebenen Solldruck. Durch die entsprechende Wölbung der Pellicles 3, 4 stellen sich dann die zur Kompensation der Abbildungsfehler des optischen Systems erforderlichen astigmatischen Abbildungseigenschaften des Transmissionselements 1 ein.

Über die Formgebung der eingespannten Randkontur der Pellicles 3, 4 ist eine Vorgabe des astigmatischen Brennweitenverhältnisses des Transmissionselements 1 bei einem bestimmten Gasdruck im Gas-Füllraum 5 möglich. Randkontur-Ellipsen mit unterschiedlichen Längenverhältnissen der Hauptachsen ergeben entsprechend unterschiedliche Abbildungseigenschaften in den den Hauptachsen zugeordneten Meridionalebenen.

Auch andere Formen der Randkontur, die eine Fläche begrenzen, die nicht zu ihrem Zentrum punktsymmetrisch ist, sind zur Vorgabe gezielt unterschiedlicher Abbildungseigenschaften in unterschiedlichen Meridionalebenen denkbar, so z.B. eine sonstige ovale Form oder eine Rechteckform.

Statt einem Pellicle 3 bzw. 4 kann auch eine Quarzplatte aus kristallinem Quarz oder Quarzglas oder eine Platte aus CaF₂ eingesetzt werden, wobei diese Platten entsprechend dünn ausgeführt sein müssen, um durch moderate Drucke deformiert werden zu können.

Statt zweier Pellicle 3, 4 kann alternativ nur ein Pellicle eingesetzt sein, wobei die gegenüberliegende, den Gas-Füllraum begrenzende optische Fläche durch eine nicht elastisch verformbare optische Komponente, z.B eine relativ dicke Glasplatte, gebildet wird. In diesem Fall kann das Pellicle oder die alternativ verwendbare deformierbare Platte aus Quarz oder CaF₂ auch mit einer Reflexionsbeschichtung versehen sein, so daß statt einem optischen Transmissionselement ein Spiegel mit einstellbarem Astigmatismus resultiert.

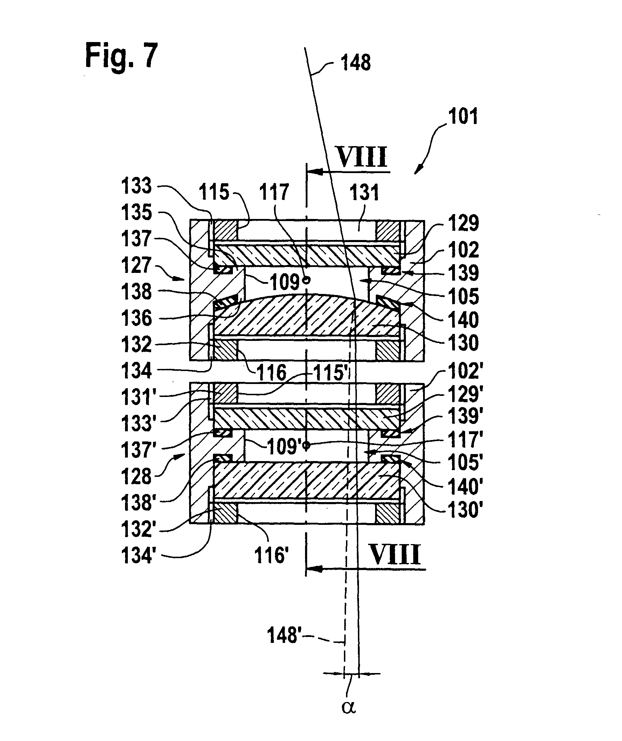

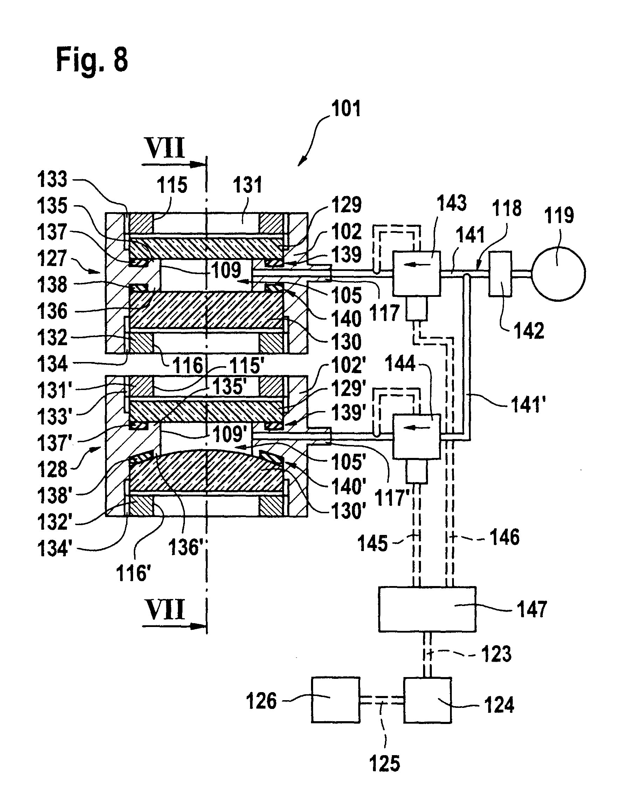

Eine nochmals alternative Ausführungsform eines Transmissionselements 101, dessen astigmatische Abbildungseigenschaften gasdruckabhängig einstellbar sind, zeigen die Figuren 7 und 8. Komponenten, die denjenigen entsprechen, die schon in den Figuren 1 bis 6 beschrieben wurden, erhalten mit um 100 erhöhte Bezugszeichen und werden nicht nochmals im einzelnen erläutert.

Das Transmissionselement 101 weist zwei längs seiner optischen Achse hintereinander angeordnete optische Komponenten 127, 128 auf. Diese sind im wesentlichen identisch aufgebaut, jedoch um die optische Achse um 90° zueinander verdreht. Aufgrund der weitgehenden Identität des Aufbaus wird im folgenden nur die optische Komponente 127 im Detail beschrieben. Wird im folgenden Bezug auf Bauteile der optischen Komponente 128 genommen, werden diese Bauteile mit gestrichenen Bezugszeichen versehen.

Die optische Komponente 127 weist eine in Figur 7 oben liegende runde Glasplatte 129 mit konstanter Stärke und eine in Figur 7 darunter angeordnete plankonvexe Zylinderlinse 130 auf. Die Glasplatte 129 und die Zylinderlinse 130 sind in einer Fassung 102 angeordnet, mit der sie einen Gas-Füllraum 105 begrenzen. Die konvex gekrümmte Oberfläche der Zylinderlinse 130 ist dem Gas-Füllraum 105 zugewandt.

Sowohl die Glasplatte 129 als auch die Zylinderlinse 130 sind aus Quarzglas.

Die Glasplatte 129 und die Zylinderlinse 130 sind mittels Vorschraubringen 131, 132 in der Fassung 102 gehaltert. Dabei sind die Vorschraubringe 131, 132, die jeweils ein Außengewinde aufweisen, in entsprechende Innengewinde 133, 134 der Fassung 102 eingeschraubt und halten die Glasplatte 129 bzw. die Zylinderlinse 130 in Anlage gegen Anlagestufen 135, 136, die in der Fassung 102 ausgebildet sind. Dichtringe 137, 138, die in Ringnuten 139, 140 liegen, die in den Anlagestufen 135, 136 ausgebildet sind, dichten die Fassung 102 gegen die Glasplatte 129 bzw. die Zylinderlinse 130 gasdicht ab.

Mit dem Gas-Füllraum 105 steht ein Einfüllstutzen 117 in Verbindung. Durch diesen erfolgt die Gaszufuhr in den Gas-Füllraum 105 über einen diesem zugeordneten Leitungsabschnitt 141 und eine Gas-Zuführleitung 118 aus einem Gas-Vorratsbehälter 119. In der Gas-Zuführleitung 118 ist eine thermostatisierte Temperiereinrichtung 142 angeordnet.

In den Leitungsabschnitten 141, 141', die über die Einfüllstutzen 117, 117' den Gas-Füllräumen 105, 105' zugeordnet sind, ist jeweils ein Druckregelventil 143, 144 angeordnet. Diese stehen über Signalleitungen 145, 146 mit einer Steuerschaltung 147 in Signalverbindung.

Das Transmissionselement 101 mit den nicht elastisch verformbare optische Oberflächen aufweisenden optischen Komponenten 127, 128 funktioniert folgendermaßen:

Analog wie beim Transmissionselement 1 liegt das CCD-Array 126 in einer Bildebene des das Transmissionselement 101 umfassenden optischen Systems der Projektions-Belichtungsanlage. Die Belichtungs-Steuerungsschaltung 124 leitet daraus Vorgabewerte für die astigmatischen Abbildungseigenschaften des Transmissionselements 101 ab, die über die Signalleitung 123 an die Steuerschaltung 147 übermittelt werden. Aus diesen Vorgabewerten berechnet die Steuerungsschaltung 147 Soll-Druckwerte für die Druckregelventile 143, 144 und übermittelt diese Soll-Druckwerte an die Druckregelventile 143, 144 über die Signalleitungen 145, 146. Die Druckregelventile 143, 144 regeln dann die Drücke in den Gas-Füllräumen 105 bzw. 105' auf die vorgegebenen Soll-Druckwerte.

Der Brechungsindex des Gases in den Gas-Füllräumen 105, 105' ist abhängig von dem dort herrschenden Gasdruck. Je höher der Gasdruck, desto höher der Brechungsindex des Gases. Dadurch sind die Abbildungseigenschaften der optischen Komponenten 127, 128 von dem jeweils in den Gas-Füllräumen 105, 105' herrschenden Gasdrücken abhängig.

Diese Abhängigkeit wird nun anhand eines Lichtstrahls 148 beschrieben, der in Figur 7 eingezeichnet ist und in deren Ebene verläuft. Der Lichtstrahl 148 dient nur zur Veranschaulichung und gibt keinen in der Praxis bei der Projektions-Belichtung verwendeten Strahlengang wieder.

Es sei angenommen, daß bei einem ersten, relativ hohen Gasdruck im Gas-Füllraum 105 der in Figur 7 oberen optischen Komponente 127 eine Brechung auf der konvexen Oberfläche der Zylinderlinse 130 derart erfolgt, daß der gebrochene Lichtstrahl 148 die nachfolgenden optischen Flächen genau senkrecht durchtritt.

Wird der Gasdruck im Gas-Füllraum 105 vermindert, ändert sich das Brechungsverhalten des Lichtstrahls 148 an den Grenzflächen zwischen dem Gas-Füllraum 105 und der Glasplatte 129 bzw. der Zylinderlinse 130. Da der Einfallswinkel des Lichtstrahls 148 bezüglich der Glasplatte 129 gering ist, kann die Änderung im Brechungsverhalten an der Grenzfläche zwischen der Glasplatte 129 und dem Gas-Füllraum 105 zur Vereinfachung der Darstellung vernachlässigt werden. Anders sind die Verhältnisse beim größeren Einfallswinkel des Lichtstrahls 148 auf die konvexe Fläche der Zylinderlinse 130. Bedingt durch den aufgrund des niedrigeren Gasdrucks im Gas-Füllraum 105 niedrigeren Brechungsindex des Füllgases erfolgt an der konvexen Oberfläche der Zylinderlinse 130 eine stärkere Brechung des Lichtstrahls 148. Im weiteren Verlauf wird dieser stärker gebrochene Lichtstrahl in Figur 7 gestrichelt dargestellt und mit dem Bezugszeichen 148' bezeichnet.

Aufgrund der stärkeren Brechung verläuft der Lichtstrahl 148' nicht mehr senkrecht zu den nachfolgenden optischen Flächen. Die Brechung an der planen optischen Oberfläche der plankonvexen Zylinderlinse 130 führt zwar zu einer Verringerung der Ablenkung des Lichtstrahls 148' gegenüber dem ursprünglichen Lichtstrahl 148, es verbleibt jedoch als Folge der Druckverringerung im Gas-Füllraum 105 eine Abweichung des Lichtstrahls 148' vom ursprünglichen Lichtstrahl 148 um einen Winkel α.

Da die im in Figur 7 dargestellten Meridionalschnitt parallelen Oberflächen der nachfolgenden optischen Elemente der optischen Komponente 128 nur zu seinem Winkelversatz des Lichtstrahl 148' führen, haben diese auf den Winkel α keinen Einfluß.

Insgesamt lassen sich also durch Änderung des Gasdrucks in einem der Gas-Füllräume 105 bzw. 105' die Brennweiten der als senkrecht aufeinander stehende Zylinderlinsen wirkenden optischen Komponenten 127, 128 unabhängig beeinflussen. Damit ergibt sich eine Einstellbarkeit des Astigmatismus des Transmissionselements 101 über das Verhältnis der Gasdrucke in den Gas-Füllräumen 105, 105'. Dieser einstellbare Astigmatismus wird zur Kompensation von Abbildungsfehlern des optischen Systems der Projektions-Belichtungsanlage eingesetzt.

Ein alternatives astigmatisches Transmissionselement mit nicht elastisch verformbaren optischen Flächen kann auch dadurch realisiert werden, daß anstelle zweier optischer Komponenten 127, 128 nur eine derartige optische Komponente eingesetzt wird, wobei statt einer Glasplatte und einer Zylinderlinse zwei um die optische Achse um 90° zueinander verdrehte Zylinderlinsen eingesetzt werden, die dem Gas-Füllraum zugewandten Flächen unterschiedlicher Krümmung aufweisen. Insgesamt weist das Transmissionselement also bei einem bestimmten Druck, z.B. Atmosphärendruck, einen Anfangs-Astigmatismus auf, der gegebenenfalls durch ein entsprechendes optisches Element kompensiert werden muß.

Da die Änderung der Ablenkung transmittierter Lichtstrahlen infolge einer gasdruckbedingten Brechungsindexänderung vom Absolutwert des Einfalls- bzw. Ausfallswinkels an den optischen Grenzflächen der Gas-Füllräume 105, 105' abhängt, ergeben sich bei einem derartigen Transmissionselement bei Gasdruckänderung unterschiedliche Änderungen der Abbildungseigenschaften in den beiden Ebenen senkrecht zu den gekrümmten Flächen der beiden Zylinderlinsen. Dies führt zu einer Verstärkung oder Abschwächung des Anfangs-Astigmatismus des Transmissionselements.

Auch in einer solchen optischen Komponente wird also ein Astigmatismus mit einem steuerbaren Verhältnis der Brennweiten in aufeinander senkrecht stehenden Ebenen zur Kompensation astigmatischer Abbildungsfehler eingesetzt. Gegebenenfalls muß ein derartiges astigmatisches Transmissionselement noch mit einer eine rotationssymmetrische Abbildungskorrektur durchführenden optischen Komponente, z.B. einem Zoom-Objektiv, kombiniert werden.

Ein durch die vorstehend beschriebenen Transmissionselemente gegebenes astigmatisches Kompensationselement ist nicht nur auf den Einsatz in einer Projektion-Belichtungsanlage beschränkt, sondern überall dort einsetzbar, wo ein steuerbarer Astigmatismus erforderlich ist. Beispiele für derartige Einsatzgebiete sind Laserresonatoren, die interne Medien, z.B. das Lasermedium, mit thermischer oder strahlungsinduzierter Doppelbrechung aufweisen, oder auch die Bündelführung von astigmatischen Laserbündeln.

Anstatt des Astigmatismus sind durch entsprechende Formgebung des optischen Kompensationselements auch andere nicht rotationssymmetrische Abbidlungseigenschaften mit n-zähliger Symmetrie einstellbar. Die Fassung eines Transmissionselements, das analog zu demjenigen der Figuren 1 bis 6 aufgebaut ist, weist hierzu eine Randkonturform auf, deren Symmetrie an die n-zählige Symmetrie des zu korrigierenden Abbildungsfehlers angepaßt ist. Ein Beispiel für eine derartige Randkonturform ist ein Vieleck. Bei einem Kompensationselement mit starren optischen Oberflächen gemäß demjenigen, das in den Figuren 7 und 8 dargestellt ist, haben entsprechend die den Gasfüllraum begrenzenden optischen Flächen eine dem zu korrigierenden Abbildungsfehler angepaßte n-zählige Symmetrie.

## Patentansprüche

1. Optisches System, insbesondere Projektions-Belichtungsanlage der Mikrolithographie, insbesondere mit schlitzförmigem Bildfeld oder nicht rotationssymmetrischer Beleuchtung,
a) mit einem optischen Element mit mindestens einem gegen den Atmophärendruck abgedichteten und von begrenzenden Flächen umschlossenen Raum mit einer Fluidfüllung, wobei zumindest eine der begrenzenden Flächen zumindest teilweise vom Beleuchtungslicht beaufschlagt wird,
b) einer Fluidquelle, die mit dem Raum über eine Fluidzuführleitung in Fluid-Verbindung steht;
c) einer Steuereinrichtung für den Druck der Fluidfüllung;
dadurch gekennzeichnet, daß
der mindestens eine umschlossene Raum (5; 105, 105') so ausgestaltet ist, daß eine Änderung des Fluiddrucks innerhalb des mindestens einen Raums (5; 105, 105') zu einer Änderung nicht rotationssymmetrischer Abbildungseigenschaften des optischen Elements (1; 101) führt, welche bezogen auf die optische Achse des optischen Elements eine n-zählige Symmetrie aufweisen, wobei n größer ist als 1.

2. Optisches System nach Anspruch 1, dadurch gekennzeichnet, daß eine Änderung des Fluiddrucks innerhalb des mindestens einen Raums (5; 105, 105') zu einer Änderung der astigmatischen Abbildungseigenschaften des optischen Elements (1; 101) führt.

3. Optisches System nach Anspruch 1 oder 2, dadurch gekennzeichnet, daß zumindest der Bereich der den Raum (5) begrenzenden Flächen, der vom Beleuchtungslicht bestrahlt wird, zumindest teilweise von einem elastisch verformbaren Medium (3, 4) gebildet wird, wobei die Randkontur (9, 10) des elastisch verformbaren Flächenbereichs nicht rotationssymmetrisch ist.

4. Optisches System nach Anspruch 3, dadurch gekennzeichnet, daß die Randkontur (9,10) bezogen auf die optische Achse des optischen Elements eine n-zählige Symmetrie aufweist, wobei n größer ist als 1.

5. Optisches System nach Anspruch 4, dadurch gekennzeichnet, daß die Randkontur (9, 10) elliptisch geformt ist.

6. Optisches System nach Anspruch 4, dadurch gekennzeichnet, daß die Randkontur die Form eines Vielecks hat.

7. Optisches System nach einem der Ansprüche 3 bis 6, dadurch gekennzeichnet, daß das elastisch verformbare optische Medium (3, 4) in seinem Randbereich von einer Halteeinrichtung (6, 11, 7, 12) gehalten wird, wobei die Form der Haltefläche, an der das optische Medium (3, 4) an der Halteeinrichtung ( 6, 11, 7, 12) anliegt, die Randkontur (9, 10) des elastisch verformbaren Flächenbereichs vorgibt.

8. Optisches System nach Anspruch 7, dadurch gekennzeichnet, daß das optische Medium ein Pellicle (3, 4) ist.

9. Optisches System nach Anspruch 7, dadurch gekennzeichnet, daß das optische Medium eine Quarzplatte ist.

10. Optisches System nach Anspruch 7, dadurch gekennzeichnet, daß das optische Medium eine Platte aus CaF₂ ist.

11. Optisches System nach einem der Ansprüche 3 bis 10, dadurch gekennzeichnet, daß das optische Medium eine Reflexionsbeschichtung aufweist.

12. Optisches System nach Anspruch 1 oder 2, dadurch gekennzeichnet, daß zumindest ein Bereich einer Fläche der den Raum (105, 105') begrenzenden Flächen vom Beleuchtungslicht (148) durchstrahlt wird und von mindestens einer starren optischen Oberfläche mit in aufeinander senkrecht stehenden Ebenen unterschiedlicher Krümmung gebildet wird.

13. Optisches System nach Anspruch 12, dadurch gekennzeichnet, daß das optische Element (101) aus einer Kombination von mindestens zwei optischen Komponenten (127, 128) gebildet wird, die jeweils mindestens einen gegen den Atmosphärendruck abgedichteten und von begrenzenden Flächen umschlossenen Raum (105, 105') mit einer Fluidfüllung, der vom Beleuchtungslicht (148) durchstrahlt wird, umfassen, wobei die optischen Komponenten (127, 128) zumindest im Bereich einer Fläche der die jeweiligen Räume (105, 105') begrenzenden Flächen je mindestens eine optische Oberfläche mit in aufeinander senkrecht stehenden Ebenen unterschiedlicher Krümmung aufweisen; und daß mittels der Steuereinrichtung (147) eine unabhängige Steuerung des Drucks der Fluidfüllung in den den optischen Komponenten (127, 128) zugeordneten Räumen (105, 105') gewährleistet ist.

14. Optisches System nach Anspruch 13, dadurch gekennzeichnet, daß das optische Element so ausgeführt ist, daß es bei gleichem Druck der Fluidfüllung in den den optischen Komponenten zugeordneten Räumen (105, 105') im wesentlichen rotationssymmetrische Abbildungseigenschaften hat.

15. Optisches System nach Anspruch 12, dadurch gekennzeichnet, daß das optische Element so ausgeführt ist, daß es bei gleichem Druck der Fluidfüllung in den den optischen Komponenten zugeordneten Räumen (105, 105') astigmatische Abbildungseigenschaften hat.

16. Optisches System nach einem der Ansprüche 12 bis 15, dadurch gekennzeichnet, daß die optische Oberfläche mit in aufeinander senkrecht stehenden Ebenen unterschiedlicher Krümmung eine Oberfläche einer Zylinderlinse (130, 130') ist.

17. Optisches System nach Anspruch 16, dadurch gekennzeichnet, daß die Zylinderlinse (130, 130') eine plankonvexe Zylinderlinse ist.

18. Optisches System nach einem der vorhergehenden Ansprüche, dadurch gekennzeichnet, daß die Steuereinrichtung (22; 147) mit einer die Abbildungseigenschaften des optischen Elements (1; 101) und/oder des optischen Systems überwachenden Sensoranordnung (26; 126) in Signalverbindung (23, 24, 25; 123, 124, 125) steht, wobei die Steuereinrichtung (22; 147) in Abhängigkeit von den übermittelten Signaldaten der Sensoranordnung (26; 126) einen Druck der Fluidfüllung vorgibt.

19. Optisches System nach Anspruch 18, dadurch gekennzeichnet, daß die Sensoranordnung (26; 126) einen positionsempfindlichen Sensor aufweist.

20. Optisches System nach Anspruch 19, dadurch gekennzeichnet, daß der positionsempfindliche Sensor (26; 126) ein CCD-Array ist.

21. Optisches System nach einem der vorhergehenden Ansprüche, dadurch gekennzeichnet, daß die Steuereinrichtung (22; 147) so ausgelegt ist, daß sie sowohl Unterdrücke als auch Überdrücke zu erzeugen vermag.

22. Optisches System nach einem der vorhergehenden Ansprüche, dadurch gekennzeichnet, daß das Fluid ein Gas ist.

23. Optisches System nach Anspruch 22, dadurch gekennzeichnet, daß das Fluid ein Edelgas ist.

24. Optisches System nach einem der Ansprüche 1 bis 21, dadurch gekennzeichnet, daß das Fluid eine Flüssigkeit ist.
